# EUROPEAN PATENT APPLICATION

(11) **EP 4 804 401 A2**
(43) Date of publication of application: **09.09.2026**
(21) Application number: 26167636.5
(22) Date of filing: 25.03.2026
(51) Int. Cl.: H03B 5/12

(54) **A DIGITALLY CONTROLLABLE OSCILLATOR**

(71) Applicant: NXP B.V., 5656 AG Eindhoven (NL); Universiteit Twente, 7522 NB Enschede (NL)
(72) Inventor: Annema, Anne Johan, 7522 NB Enschede (NL); Verlinden, Jos, 5656AG Eindhoven (NL)
(74) Representative: Schwarzweller, Thomas

(57) **Abstract**

Aspects of this disclosure are directed to, DCO circuits and methods. The DCO, comprise: an inductance-capacitance, (LC), resonant circuit having a first branch connected in parallel with a second branch, each branch comprising a capacitor and an inductive-element connected in series with the capacitor; a first transistor connected, by its main terminals, across the capacitor of the first branch; a second transistor connected, by its main terminals, across the capacitor of the second branch; and a biasing current source arranged and connected to provide current to the resonant circuit; wherein a control terminal of the transistor of each branch is connected to a node between the respective capacitor and respective inductive-element of an opposite branch, and wherein at least one of the first transistor and second transistor is controllable to adjust a transconductance of the respective branch.

## Description

### FIELD OF THE DISCLOSURE

The present disclosure relates to digitally controllable oscillators (DCO), in particular to LC oscillators which are digitally tuneable.

### BACKGROUND

For applications such as all digital phase locked loops (ADPLL), precisely controllable DCOs are often required, with high resolution frequency tuning. In particular, the LC- tank frequency of an LC tank DCO may be required to be tuneable or adjustable by very small frequency steps, which may be smaller than one part per million (<1 ppm). Conventionally controlled DCOs typically use a variable capacitor, for example driven by a digital to analog controller (DAC), or banks of switchable capacitors to control the frequency, but for such precise control a sufficiently quantized capacitor bank would be impracticable. Instead, in order to address this limitation, sigma-delta modulation is commonly employed to enhance the tuning resolution. However, there are disadvantages associated with sigma-delta modulation, since it results in instantaneous phase noise, spurs, and jitter. Alternative means of providing enhanced resolution would be desirable.

### SUMMARY

According to a first aspect of the present disclosure, there is provided a digitally controlled oscillator, DCO circuit, comprising: an inductance-capacitance, LC, resonant circuit having a first branch connected in parallel with a second branch, each branch comprising a capacitor and an inductive-element connected in series with the capacitor; a first transistor connected, by its main terminals, across the capacitor of the first branch; a second transistor connected, by its main terminals, across the capacitor of the second branch; and a biasing current source arranged and connected to provide current to the resonant circuit; wherein a control terminal of the transistor of each branch is connected to a node between the respective capacitor and respective inductive-element of an opposite branch, and wherein at least one of the first transistor and second transistor is controllable to adjust a transconductance of the respective branch. By controlling or adjusting the relative transconductance associated with each the two branches, it is possible to make the DCO operate as a conventional cross-coupled oscillator, (when the transconductances of each branch are equal), or in a mode which is hybrid between cross-coupled oscillator oscillation and Colpitts operation.

In one or more embodiments the first and second branches are commonly connected directly between a first supply terminal and a first terminal of the current source, and a second terminal of the current source is connected to a ground terminal.

Alternatively, the current source may be provided elsewhere in the circuit; for example, in one or more other embodiments the first and second branches are commonly connected directly between a first terminal of single current source, being the at least one current source, and a ground terminal, wherein a second terminal of the at least one current source is connected to a supply terminal other than ground.

In one of more other embodiments, the at least one current source comprises a first current source and a second current source; the first and second branches are commonly connected, at a respective first end, to a ground node, and are each connected, at a respective second end, to a respective terminal of an isolation capacitor; and a first terminal of the respective first and second current source is connected to a respective mid-point node between the capacitor and the inductive-element of the respective branch, wherein a second terminal of the current sources are commonly connected to a voltage supply node other than the ground node
In one or more yet other embodiments, the at least one current source comprises a first current source and a second current source; the first and second branches are commonly connected, at a respective first end, to a ground node, and are commonly connected at a respective second end; and a first terminal of the respective first and second current source is connected to a respective mid-point node between the capacitor and the inductive-element of the respective branch, wherein a second terminal of the current sources are commonly connected to a voltage supply node other than the ground node.

The inductive-element of the first and second branches may together be implemented as a single inductor. In other embodiments, the inductive-element of each of the first and second branches may be separately be implemented as a single inductor, or a plurality of inductors connected in series, parallel, or a combination thereof, as appropriate for specific application or circuit implementations.

In one or yet other more embodiments the first and second branches are commonly connected, at a respective first end, to a first supply terminal, and are each connected, at a respective send end, to a respective terminal of an isolation capacitor and a first terminal of a respective first and second current source, wherein a second terminal of the respective current source is each connected to a ground terminal. The isolation capacitor made us provide DC isolation allowing for separate biasing of the transistors, whilst forming part of the LC circuit.

In one or more such embodiments the biasing current source is a one of the respective current sources.

In one or more embodiments a one of the first and second current source is adjustable to control the respective one of the first transistor and second transistor. The transconductance of the associated branch may thereby adjusted or controlled.

In one or more embodiments the other of the first and second current source is configured to provide a bias current Ibias, and the one of the first and second current sources is adjustable between 0 and Ibias over N steps. In one or more such embodiments N is in a range of 16 to 128. In other embodiments a different step size may be used. Moreover the current source may be adjustable over a different range, or maybe continuously adjustable, for instance in an analogue manner, rather than stepwise or digitally adjustable.

In one or more embodiments at least one of the first and second transistor is an adjustable transistor having an adjustable gate width. In one or more such embodiments the adjustable transistor comprises a plurality of gates elements each of which may be connected or disconnected, thereby to adjust the gate width. In one or more such embodiments at least one of the number, and the widths, of the plurality of the gates elements are such that the gate width may be adjusted in N steps, wherein N is in a range of 16-128.

In one or more embodiments the capacitor in a one of the first and second branch is a first variable capacitor comprising a plurality of parallel capacitive elements each of which may be separately connected or disconnected. Including such a switchable capacitor bank may be useful for providing at coarse tuning of the frequency, and in particular may be used and useful in addition to the fine tuning provided by the transitioning between cross-coupled and Colpitts operation.

In one or more embodiments the capacitor in the other of the first and second branch is a second variable capacitor comprising a plurality of parallel capacitive elements each, or some, of which may be separately connected or disconnected.

According to a second aspect of the present disclosure, there is provided a method of operating a digitally controlled oscillator, DCO circuit, just described, the method comprising: controlling at least one of the first transistor and second transistor to adjust a transconductance of the respective branch.

In one or more embodiments controlling at least one of the first and second transistors to adjust a transconductance of the respective branch comprises: controlling a bias current of the current source.

In one or more embodiments controlling at least one of the first transistor and second transistor to adjust a transconductance of the respective branch comprises: controlling a gate with of the at least one of the first transistor and second transistor.

In one or more embodiments the capacitor in a one of the first and second branch is a first variable capacitor comprising a plurality of parallel capacitive elements each of which may be separately connected or disconnected; and controlling at least one of the first transistor and second transistor to adjust a transconductance of the respective branch comprises controlling the first variable capacitor. In other embodiments, the capacitor may be a varicap.

In one or more embodiments the capacitor in the other of the first and second branch is a second variable capacitor comprising a plurality of parallel capacitive elements each of which may be separately connected or disconnected; and controlling at least one of the first transistor and second transistor to adjust a transconductance of the respective branch comprises controlling the second variable capacitor.

### BRIEF DESCRIPTION OF THE DRAWINGS

Reference will now be made to the accompanying drawings, wherein:
FIG. 1 shows a schematic circuit diagram of a Colpitts oscillator;
FIG. 2 shows a schematic circuit diagram of a cross-coupled oscillator;
FIG. 3 shows a schematic circuit diagram of a modified Colpitts oscillator;
FIG. 4 shows a schematic circuit diagram of an oscillator according to embodiments of the present disclosure;
FIG. 5 shows a schematic circuit diagram of an oscillator according to other embodiments of the present disclosure;
FIG. 6 shows a schematic circuit diagram of an oscillator according to further embodiments of the present disclosure;.
FIG. 7 shows a schematic circuit diagram of an oscillator according to yet further embodiments of the present disclosure; and
FIG. 8 shows a schematic circuit diagram of an oscillator according to yet other embodiments of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

The present inventors have made the surprising recognition that the similarities and differences between cross-coupled LC tank oscillators and Colpitts oscillators may be exploited to provide very high resolution tuning of an LC oscillator.

Viewed in general terms, a Colpitts oscillator is an LC oscillator in which a capacitive divider provides frequency-selective positive feedback to an active device, sustaining a sinusoidal output at the LC resonance frequency.

The oscillation frequency is given, in general terms, by equation (1): ${f}_{{osc}_{Colpitts}} \approx \frac{1}{2 π \sqrt{L {. C}_{s}}} ,$ where C_{S} is the capacitance of the capacitive divider and L is the total inductance of the LC resonant circuit.

In a real application, both the inductor and the capacitors are lossy in the sense that they are not purely reactive, with only virtual impedance, but include a real impedance R_{S} and have an associated, frequency dependent quality factor Q given by, for an inductor: ${Q}_{L} \left(ω\right) = \frac{ω . L}{{R}_{S}} ,$ and for a capacitor: ${Q}_{C} \left(ω\right) = \frac{1}{ω . C {. R}_{S}} .$ When these losses are included, the oscillation frequency of a Colpitts oscillator can be expressed more accurately, as ${f}_{{osc}_{Colpitts}} = \frac{1}{2 π \sqrt{L {. C}_{s}}} ⋅ \sqrt{1 + \frac{2 . {Q}_{C} + 2 . {Q}_{L}}{{Q}_{C}^{2} ⋅ {Q}_{L} - 2 . {Q}_{C} - {Q}_{L}}}$

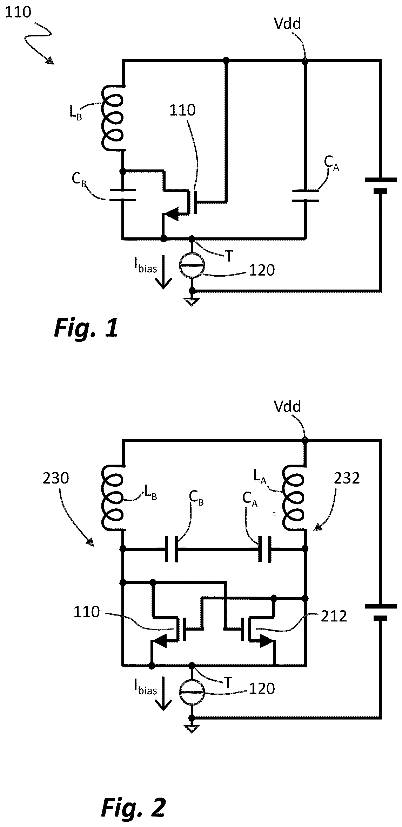

An example of a Colpitts oscillator is shown in Fig. 1. The resonant LC tank is formed by the series combination of the inductor L_{B} and the two capacitors C_{B} and C_{A}. A transistor 110, which in this example is an N-FET 110, is connected with its main terminals across one of the capacitors: in this example C_{B}. The control or gate terminal of the transistor 110 is connected to the supply node V_{dd}. A current source 120 is provided, at a tail node T in the resonant tank, to supply a bias current I_{bias} to the circuit. A variant of the Colpitts oscillator is the Clapp oscillator, also referred to as a Gouriet oscillator, in which an additional capacitor is included in series with the inductor. As used herein, the term Colpitts oscillator shall be interpreted broadly, so as to include variants such as the Clapp oscillator.

Whereas in a Colpitts oscillator, the feedback is provided from the capacitor divider; in a cross-coupled oscillation, the feedback is provided entirely by active the components - that is to say, the transistors - which form the cross-coupling. An example of an LC tank cross-coupled oscillator is shown in FIG. 2. The oscillation frequency is set, in general terms by the LC tank ${f}_{{osc}_{C - Coupled}} \approx \frac{1}{2 π \sqrt{L . C}} ,$ where L is the total inductance of the inductors L_{A} and L_{B} in each of the branches 232 and 230, and C is the total capacitance of the (series combination of the) capacitors C_{A} and C_{B} in or associated with each branch.

When the losses associated with the capacitors and inductors are taken into account, the frequency of oscillation can be described, more accurately, as: ${f}_{{osc}_{C - Coupled}} = \frac{1}{2 π \sqrt{L {. C}_{s}}} ⋅ \sqrt{1 - \frac{{Q}_{C}^{2} - {Q}_{L}^{2}}{{Q}_{C}^{2} ⋅ \left({Q}_{L}^{2}+1\right)}} .$

The skilled person will appreciate that parasitic capacitances in the FETs may be taken into account in the above equation, by including such parasitic components in the formulation of C_{A} and C_{B}.

By comparing equation (4) with (6) it can be seen that the frequency of a Colpitts oscillator deviates from that of a cross-coupled oscillator, by an amount which is relatively small (in comparison with the nominal frequency) and depends on the quality factor Q of the components. To a first approximation, the deviation is typically of the order of 0.05% (that is to say, a few tens or a few hundred parts per million). The present inventors have appreciated that it is possible to design an oscillator which may operate either as a Colpitts oscillator or as a cross-coupled oscillator, and in particular which may operate in a hybrid mode which is some combination of the two. By adjusting the hybrid operation mode so as to more closely resemble cross-coupled operation, the frequency may be adjusted towards that shown in equation 6; conversely by adjusting the hybrid operation mode so as to most more closely resemble Colpitts operation, the frequency may be adjusted towards that shown in equation 4. Since, in each case, the deviation from the nominal operating frequency of the LC tank is small, the actual operating frequency may be changed with very high resolution, stepwise, between the two.

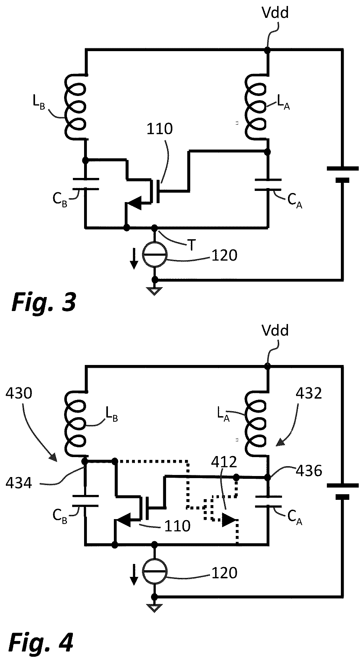

FIGs. 3 and 4 illustrate how to construct an oscillator which may operate in cross-coupled mode, or, in a "Colpitts-like" mode, or somewhere in between. Turning first to FIG. 3, this shows a variant of a Colpitts oscillator. The skilled person will appreciate that it is not important whether this specific circuit can operate as a functional oscillator - rather, the figure is included in order to assist in understanding how oscillators according to the present disclosure may be considered to have a Colpitts operating mode in addition to the cross-coupled operating mode. It can be seen that, relative to the circuit shown in FIG.1, in the circuit of FIG. 3, the inductance L has been separated into two separate inductors, or separate parts L_{A} and L_{B}, with a centre tap therebetween. Moreover, the supply voltage, Vdd, node is connected to the centre tap between L_{A} and L_{B} instead of being at one end of the inductor L. Apart from those differences, which may be anticipated to have little or no impact on the operation of the circuit and its associated resonant frequency, the circuit is the same as a normal Colpitts oscillator.

Turning now to FIG. 4, this shows an oscillator according to embodiments of the present disclosure. The addition, compared with FIG. 3, of a second transistor 412, implemented in this illustrative example as an N-FET, provides, in conjunction with the transistor 110, allows cross-coupling and thereby allows the circuit to operate as a cross-coupled oscillator.

In order to transition, through a series of steps or stages, from Colpitts operating mode (transistor 412 disconnected or effectively disconnected) to cross-coupled mode (transistor 412 present), the transistor 412 can be "step-wise" included. One way to achieve this, according to one or more embodiments, is to adjust the gate width, or effective gate width of the FET from effectively 0, (transistor effectively disconnected or disabled) to the same gate width as FET 110, in a series of N steps. In a typical application, the number of steps may be between 10 and 100, although fewer, or more, steps may be used or available where that is appropriate. The skilled person will be familiar with FET designs which allow for digitally controllable step-wise variable gate width. Conceptually, adjusting the gate width of the FET 412 alters an effective transconductance of the "branch" L_{A} and C_{A} between the supply node Vdd and the tail node T. The skilled person will appreciate the, viewed from another perspective, the transition between Colpitts and cross-coupled operation corresponds to, or is effected by, altering an effective transconductance ratio between the first branch (that is to say, L_{A} and C_{A}) and the second branch (that is to say, L_{B} and C_{B}).

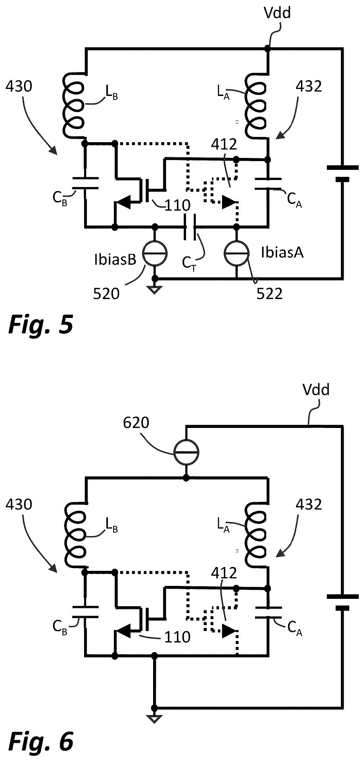

An alternative way to vary the transconductance ratio between the two branches, according to one or more other embodiments, is to adjust the relative bias current or currents for each branch. FIG. 5 illustrates a circuit in which this is achieved, in this nonlimiting example by splitting the bias current into two parts, and directing each part separately to a different one of the two branches. Thus, the circuit of FIG. 5 is similar to that in FIG. 4, except that the "capacitance" part of the LC resonant tank is split into three, rather than two, separate parts. In addition to the capacitors in each branch (C_{A} and C_{B}), a third capacitor (C_{T}) is introduced therebetween. The third capacitor may also referred to as an isolation capacitor since it provides DC isolation allowing for independent biasing of the branches' transistors. Instead of a single bias current, provided from a single current source, which is typically at the tail node, a separate bias current I_{biasA} and I_{biasB} is provided to each branch, by connecting a respective current source between each branch and ground, one each side of the third capacitor C_{T}.

The transconductance gm of a FET is related to its gate width W and gate length L through: ${g}_{m} = {μC}_{ox} \frac{W}{L} \left({V}_{gs}-{V}_{T}\right)$ so setting ${μC}_{ox} \frac{W}{L} = K$ , and (VgS-V_{T}) = V_{OV}, gives ${g}_{m} = \frac{2 {I}_{D}}{{V}_{OV}} ,$ for strong inversion (such as for high bias currents), and for weak inversion (such as low bias currents): ${g}_{m} = 2 . K {. I}_{d} .$ Thus varying the relative bias currents can shift the operation of the oscillator between being "Colpitts-like" and "classical cross-coupled-like".

Turning now to FIG. 6, this shows an oscillator according to one or more other embodiments of the present disclosure. The circuit shown in FIG. 6 is similar to that shown in FIG.4, except for the current source. Whereas in FIG.4 the current source is located as a tail current source between a ground node and the lower ends of the two branches 430 and 432, in FIG. 6 the lower ends of the two branches 430 and 432 are connected directly to ground, and the current source 620 is placed between the supply note Vdd and the upper end of the two branches.

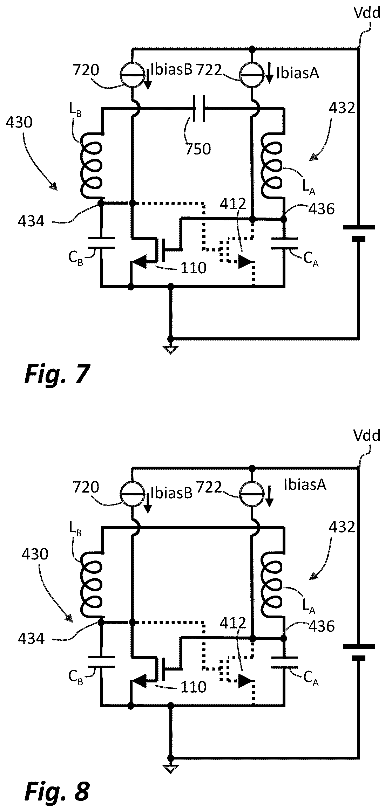

FIG. 7 shows an oscillator according to other embodiments of the present disclosure. This circuit is similar to that shown in FIG. 5, and includes two current sources 720 and 722 to provide separate bias currents IbiasB and IbiasA to the two respective branches 430 and 432, and furthermore includes an isolation capacitor 750 to enable independent biasing of the two branches. However, in the circuit of FIG. 7, the biasing currents are provided to midpoint nodes of the respective branches, and the DC isolation capacitor 750 is located between the upper ends of the branches.

FIG. 8 shows an oscillator according to yet other embodiments of the present disclosure. The circuit shown in this figure is similar to that shown in FIG. 7 apart from the absence of the isolation capacitor 750. The skilled person will appreciate that since the biasing currents are provided to the midpoint nodes of the two branches, a level of isolation between the branches enabling separate biasing is provided by the inductors L_{A} and L_{B}. Furthermore, the skilled person will readily appreciate that the inductors L_{A} and L_{B}, may be implemented as a single inductor. L_{A} and L_{B}, may thus be considered as inductive-elements, which may be implemented combined into a single inductor, or as separate inductors. In such embodiments, the LC resonant tank takes the form of a CLC tank, formed from C_{B} + (L_{B} & L_{A}) +C_{A}.

The skilled person will appreciate that, although the circuits FIGs. 4 to 8 have been implemented using N-FETs, and NMOS in particular, the present disclosure is not limited thereto, and the circuit may alternatively be implemented using P-FETs such as PMOS transistors, or a combination thereof.

In a nonlimiting example application, the oscillator may operate in a frequency range at or about 2GHz, and the LC resonant tank may include inductors in a 50-200pH range, and capacitors in a range of 2-10 pF. The skilled person will appreciate that such inductors and capacitors may be provided as on-chip, or integrated, passive components, that is to say they may be manufactured as part of an integrated circuit, with physical sizes of the order of 100 µm by 100 µm. However, the present disclosure is not limited to such frequency ranges or indeed to integrated passive components, and may extend to oscillators having external discrete inductors or capacitors.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

## Claims

1. A digitally controlled oscillator, DCO, circuit, comprising:
an inductance-capacitance, LC, resonant circuit having a first branch connected in parallel with a second branch, each branch comprising
a capacitor and an inductive-element connected in series with the capacitor;
a first transistor connected, by its main terminals, across the capacitor of the first branch;
a second transistor connected, by its main terminals, across the capacitor of the second branch;
and at least one biasing current source arranged and connected to provide current to the resonant circuit;
wherein a control terminal of the transistor of each branch is connected to a node between the respective capacitor and respective inductive-element of an opposite branch, and
wherein at least one of the first transistor and second transistor is controllable to adjust a transconductance of the respective branch.

2. The DCO circuit of claim 1, wherein
the first and second branches are commonly connected directly between a first supply terminal and a first terminal of the at least one current source, wherein a second terminal of the current source is connected to a ground terminal.

3. The DCO circuit of claim 1, wherein
the first and second branches are commonly connected directly between a first terminal of the current source and a ground terminal, wherein a second terminal of the at least one current source is connected to a supply terminal other than ground.

4. The DCO circuit of claim 1, wherein

5. the first and second branches are commonly connected directly between a first supply terminal and a first terminal of the current source, wherein a second terminal of the current source is connected to a ground terminal.
